(19) Europäisches Patentamt / European Patent Office / Office européen des brevets

(11) **EP 2 352 237 A1**

(12) **EUROPEAN PATENT APPLICATION**
published in accordance with Art. 153(4) EPC

(43) Date of publication:
**03.08.2011 Bulletin 2011/31**

(51) Int Cl.:
***H04B 3/23*** (2006.01)   ***H03H 21/00*** (2006.01)
***H04R 3/02*** (2006.01)

(21) Application number: **09825904.7**

(22) Date of filing: **11.11.2009**

(86) International application number:
**PCT/JP2009/006017**

(87) International publication number:
**WO 2010/055650 (20.05.2010 Gazette 2010/20)**

(84) Designated Contracting States:
**AT BE BG CH CY CZ DE DK EE ES FI FR GB GR
HR HU IE IS IT LI LT LU LV MC MK MT NL NO PL
PT RO SE SI SK SM TR**

(30) Priority: **14.11.2008 JP 2008292330**

(71) Applicant: **Yugengaisya Cepstrum
Tokyo 206-0021 (JP)**

(72) Inventor: **YAMAGUCHI, Akio
Tokyo 206-0021 (JP)**

(74) Representative: **Hager, Thomas Johannes
Hoefer & Partner
Patentanwälte
Pilgersheimer Strasse 20
81543 München (DE)**

(54) **ADAPTIVE FILTER AND ECHO CANCELLER HAVING SAME**

(57)      Disclosed is an adaptive filter that prevents adaptation error from increasing in a state of double talk, without providing a double-talk detection circuit. In this adaptive filter, using input signal x[n] and error signal e[n], a tap coefficient setting section (202) calculates a numerator term of update coefficient $\Delta w_n[i]$ in a delay circuit (301) and a multiplier (302), and calculates a normalized denominator term of update coefficient $\Delta w_n[i]$ in a multiplier (303), a multiplier (304), an adder (305), an averaging circuit (306), and an adder (307). The tap coefficient setting section (202) divides the numerator term by the normalized denominator term in a reciprocal computation circuit (308) and a multiplier (309) and calculates update coefficient $\Delta w_n[i]$. The tap coefficient setting section (202), in a multiplier (310), an adder (311), and a delay circuit (312), adds update coefficient $\Delta w_n[i]$ multiplied by step size $2\mu$ to tap coefficient $w_n[i]$ and generates updated tap coefficient $w_{n+1}[i]$.

FIG.3

EP 2 352 237 A1

**Description**

Technical Field

The present invention relates to an adaptive filter that generates pseudo echo by computing a received speech signal using a tap coefficient, and also relates to an echo canceller that eliminates echo using pseudo echo generated in this adaptive filter.

Background Art

Following the advancement in the mode of communication and hardware, we have increasing opportunities to use microphones. A microphone generally picks up sound/voice output from a speaker and indirect waves (echo) reflected on the walls of a room, in addition to the desired sound/voice, and, if these are output as is from a speaker, the speaking party's voice is heard with a delay and this is very annoying. Also, with a hands-free telephone, there are cases where a specific frequency component of echo is amplified and produces howling (oscillation phenomenon).

An echo canceller is a system for eliminating this echo. That is, an echo canceller updates the tap coefficient of an adaptive filter to be equal to the transfer function from the speaker to the microphone, and subtracts the signal (hereinafter "pseudo echo") obtained by processing an input signal using this tap coefficient, from the speech signal collected by the microphone. By this means, an echo component is suppressed in the signal (hereinafter "error signal") output from the echo canceller.

The adaptive filter generates pseudo echo by computing the input speech at time n using tap coefficient $w_n[i]$ at discrete time n. Also, the adaptive filter updates tap coefficient $w_n[i]$ by a predetermined adaptation algorithm. Here, n is the sample time index and i is a parameter (index) to show the tap position of the adaptive filter.

The recurrence equation of the update of tap coefficient $w_n[i]$ is generally represented by following equation 1. In equation 1, $w_n[i]$ is the tap coefficient prior to adaptation, $w_{n+1}[i]$ is the tap coefficient after adaptation, $\mu$ is the step size to adjust the rate of convergence of the tap coefficient, and $\Delta w_n[i]$ is the update coefficient. Update coefficient $\Delta w_n[i]$ varies depending on the type of the adaptation algorithm.

[1]

$$w_{n+1}[i] = w_n[i] + \mu \cdot \Delta w_n[i]$$

... (Equation 1)

Generally, an adaptive filter is defined as a filter to subject a signal that is received as input in a certain system with an unknown transfer function, to filtering processing, and that updates the tap coefficient in the filtering processing such that the system output signal to be output from the system and the signal after the filtering processing are equal.

Now, the operation of adaptive estimation in the adaptive filter is executed normally in a single-talk state in which there is only a speech signal from a far-end speaking party.

However, an adaptation algorithm heretofore does not take into account the influence of speech (that is, additive noise) from a near-end speaking party. Consequently, in a state of "double talk" in which a speech signal from a near-end speaking party (that is, "near end signal") and a speech signal from a far-end speaking party (that is, "far end signal") overlap one another, there is a threat that, by updating the adaptive filter, the adaptation error of the adaptive filter increases and leads to saturation of tap coefficient $w_n[i]$.

To combat this problem, the prior art provides a double-talk detection circuit to detect whether or not there is a double-talk state, and, when a double-talk state is found, stops the adaptive estimation operation of the adaptive filter or makes the step size, $\mu$, of the adaptation algorithm small (see, for example, patent literature 1, patent literature 2 and patent literature 3).

Citation List

Patent Literature

PTL 1

Japanese Patent Application Laid-Open No. 2007-274714
PTL 2
Japanese Patent Application Laid-Open No. 2008-78973
PTL 3
Japanese Patent Application Laid-Open No. 2008-98929

Summary of Invention

Technical Problem

With a technique to provide a double-talk detection circuit like the prior art, it takes time to find an optimal threshold value for determining whether or not there is a double-talk state. Furthermore, generally, it is difficult to detect a double-talk state accurately, and, depending on the prior art, it is difficult to maintain a good convergence behavior of an adaptive filter.

It is therefore an object of the present invention to provide an adaptive filer and echo canceller that can prevent adaptation error from increasing in a double-talk state without providing a double-talk detection circuit.

Solution to Problem

An adaptive filter according to the present invention has: a filter section that receives input signal $x[n]$ that is equal to an system input signal entered in a system with an unknown transfer function, and that outputs output signal $y[n]$ by performing filtering processing of input signal $x[n]$; and a coefficient setting section that updates tap coefficient $w_n[i]$ in the filtering processing to be equal to the transfer function of the system, based on error signal $e[n]$ representing a difference between system output signal $d[n]$ that is output from the system and output signal $y[n]$, and input signal $x[n]$, where n is a sample time index and i is a parameter to represent a tap position of the adaptive filter, and, with this adaptive filer, the tap coefficient setting section: generates updated tap coefficient $w_{n+1}[i]$ by adding a result of multiplication of step size $2\mu$ and update coefficient $\Delta w_n[i]$ to tap coefficient $w_n[i]$; generates update coefficient $\Delta w_n[i]$ by dividing a numerator term by a normalized denominator term; generates the numerator term by multiplying input signal $x[n-i]$ by error signal $e[n]$; generates the normalized denominator term by one of: adding positive constant c to an average of a sum of a square of input signal $x[n]$ and a square of error signal $e[n]$; adding positive constant c to a square root of an average of an product of the square of input signal $x[n]$ and the square of error signal $e[n]$; and adding positive constant c to an average of an absolute value of the product of input signal $x[n]$ and error signal $e[n]$.

An echo canceller according to the present invention has: the above adaptive filter; and a subtractor that generates error signal $e[n]$ by subtracting output signal $y[n]$ that is output from the adaptive filter, from system output signal $d[n]$.

Advantageous Effects of Invention

According to the present invention, it is possible to maintain an optimal rate of convergence automatically by controlling the rate of convergence based on the power of a far-end signal and the power of a near-end signal, and consequently achieve a good and stable convergence behavior. Furthermore, with the present invention, it is possible to slow down the rate of convergence in a double-talk state and prevent the adaptation error from increasing.

Brief Description of Drawings

FIG.1 is a block diagram showing a configuration of a digital communication apparatus having an echo canceller according to an embodiment of the present invention;
FIG.2 is a block diagram showing an inner configuration of an adaptive filter according to an embodiment of the present invention;
FIG.3 shows a configuration of a computation circuit in a tap coefficient setting section in an adaptive filter according to an embodiment of the present invention in the event of equation 2;
FIG.4 shows a configuration of a computation circuit in a tap coefficient setting section in an adaptive filter according to an embodiment of the present invention in the event of equation 3;
FIG.5 shows a configuration of a computation circuit in a tap coefficient setting section in an adaptive filter according to an embodiment of the present invention in the event of equation 4;
FIG.6 shows a simulation result of an adaptive filter according to an embodiment of the present invention;

FIG.7 shows a system configuration upon a simulation of an adaptive filter according to an embodiment of the present invention;

FIG.8 shows a configuration of a computation circuit in a tap coefficient setting section in an adaptive filter according to an embodiment of the present invention in the event of equation 6;

FIG.9 shows a configuration of a computation circuit of a tap coefficient setting section of an adaptive filter according to an embodiment of the present invention in the event of equation 7; and

FIG.10 shows a result of a computer simulation performed to prove the effectiveness of an adaptive filter according to an embodiment of the present invention.

Description of Embodiments

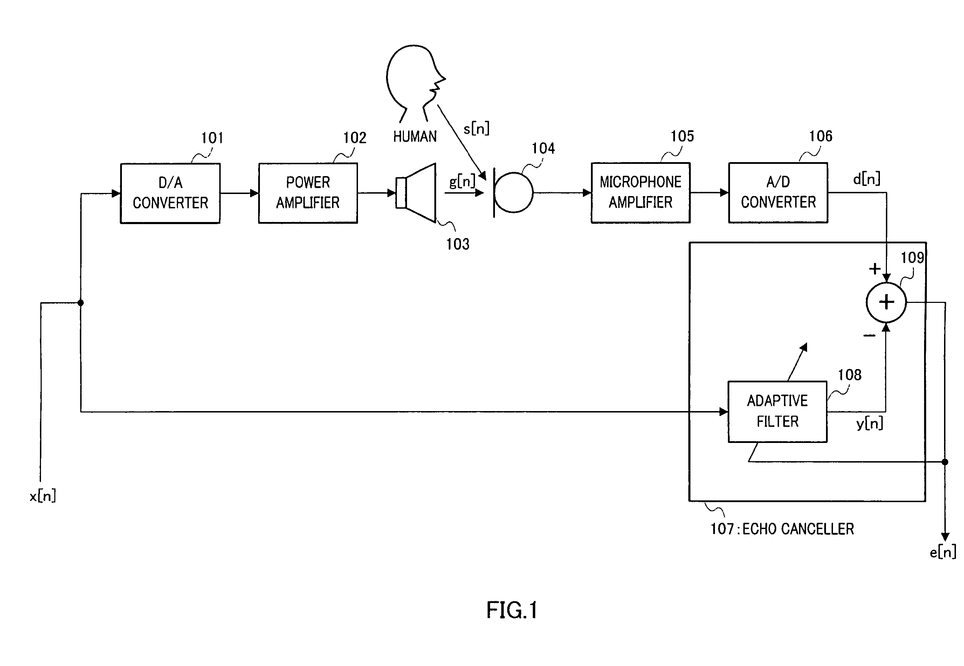

Now, embodiments of the present invention will be described below in detail with reference to the accompanying drawings. FIG.1 is a block diagram showing a configuration of a digital communication apparatus having an echo canceller according to an embodiment of the present invention.

As shown in FIG.1, a digital communication apparatus is formed primarily with digital-to-analog ("D/A") converter 101, power amplifier 102, speaker 103, microphone 104, microphone amplifier 105, analog-to-digital ("A/D") converter 106, and echo canceller107. Echo canceller107 has adaptive filter 108 and sub tractor 109.

In an receiving circuit (not shown), as a result of performing processing such as demodulation and decoding upon a signal transmitted from an apparatus of a communicating party, digital received speech signal $x[n]$ is acquired. Digital received speech signal $x[n]$ is an input signal in adaptive filter 108.

D/A converter101 converts digital received speech signal $x[n]$ into an analog speech signal. The analog received speech signal is amplified in power amplifier 102 and output as speech from speaker 103.

The analog transmission speech signal that is input in microphone 104 is amplified in microphone amplifier 105 and is input in A/D converter 106. In microphone 104, input speech $s[n]$ from a near-end speaking party and speech $g[n]$ playing from speaker 103 are input as echo. Input speech from a near-end speaking party is equivalent to additive noise that affects the convergence of adaptive filter 108.

A/D converter 106 converts the analog transmission speech signal into a digital transmission speech signal $d[n]$.

Echo canceller 107 updates tap coefficient $w_n[i]$ of adaptive filter108 to be equal to the impulse response of the transfer function from D/A converter 101 to A/D converter 106. Power amplifier 102 and microphone amplifier 105 generally have a flat frequency behavior, so that $w_n[i]$ becomes equal to the impulse response of the transfer function from speaker 103 to microphone 104. Then, echo canceller107 subtracts pseudo echo $y[n]$, which is obtained by processing digital received speech signal $x[n]$ using tap coefficient $w_n[i]$, from digital transmission speech signal $d[n]$, and outputs error signal $e[n]$ in which echo is suppressed.

Adaptive filter 108 generates pseudo echo $y[n]$ by operating digital received speech signal $x[n]$ at discrete time $n$ using tap coefficient $w_n[i]$. Furthermore, adaptive filter 108 updates tap coefficient $w_n[i]$ using a predetermined adaptation algorithm, based on error signal $e[n]$ and digital received speech signal $x[n]$ output from sub tractor 109. Note that $i$ is a parameter (index) to represent the tap position of the adaptive filter.

Subtractor 109 subtracts pseudo echo $y[n]$ from digital transmission speech signal $d[n]$ output from A/D converter 106, and acquires error signal $e[n]$. Error signal $e[n]$ is subjected to processing such as encoding and modulation in a transmission circuit (not shown), and is transmitted to an apparatus of a communicating party.

Next, the inner configuration of adaptive filter 108 will be described with reference to drawings. In the following description, a digital received speech signal $x[n]$ is the input signal and pseudo echo $y[n]$ is the output signal.

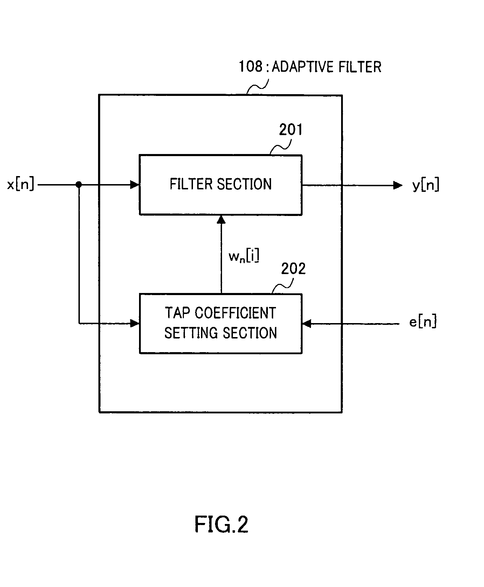

FIG.2 is a block diagram showing an inner configuration of adaptive filter 108. As shwon in FIG.2, adaptive filter 108 has filter section 201 and tap coefficient setting section 202.

Filter section 201 is, for example, an FIR filter and generates output signal $y[n]$ by computing (that is, by filtering) input signal $x[n]$ using tap coefficient $w_n[i]$.

Tap coefficient setting section 202 sets tap coefficient $w_n[i]$ based on a predetermined adaptation algorithm using input signal $x[n]$ and error signal $e[n]$, and outputs tap coefficient $w_n[i]$ to filter section 201. A feature of the present invention lies in this adaptation algorithm computation circuit in tap coefficient setting section 202.

The adaptive filter of the present invention in the event an NLMS (Normalized Least Mean Square) algorithm is used as an adaptation algorithm will be described below. The NLMS algorithm is an adaptation algorithm to perform time domain processing, and perform a computation every time a new signal sampling value is received as input, so that the tap coefficient gradually converges to an optimal value.

When an NLMS algorithm is used, the updated recurrence equation of tap coefficient $w_n[i]$ of the present invention is represented by one of following equation 2 to equation 4. From equation 2 to equation 4, $w_n[i]$ is the tap coefficient prior to adaptation (that is, at time $n$), $w_{n+1}[i]$ is the tap coefficient after adaptation (that is, at time $n+1$), $2\mu$ is the step size to adjust the rate of convergence of the tap coefficient, $x[n]$ is an input signal, $e[n]$ is an error signal, and $c$ is a small constant of a positive value for not making the value of the denominator of a fraction zero. Furthermore, the symbol "-" is a short time average of signal.

[2]

$$w_{n+1}[i] = w_n[i] + 2\mu \frac{e[n] \, x[n-i]}{x^2[n] + e^2[n] + c}$$

... (Equation 2)

[3]

$$w_{n+1}[i] = w_n[i] + 2\mu \frac{e[n] \, x[n-i]}{\sqrt{\overline{x^2[n] \, e^2[n]}} + c}$$

... (Equation 3)

[4]

$$w_{n+1}[i] = w_n[i] + 2\mu \frac{e[n] \, x[n-i]}{\left| \overline{x[n] \, e[n]} \right| + c}$$

... (Equation 4)

The short time average is determined by integration processing using a moving average of a finite number of past samples or a forgetting factor. Assuming that the data length for averaging is N, a moving average can be calculated using an N-tap FIR filter having all-1/N tap coefficients. Also, integration processing using forgetting factor $\alpha$ is defined by equation 5 below. Equation 5 assumes a case where a short time average of input signal f[n] is found.

[5]

$$\overline{f[n]} = (1-\alpha) \overline{f[n-1]} + \alpha \cdot f[n]$$

... (Equation 5)

Equation 2 to equation 4 are all different from a conventional NLMS algorithm in that normalization processing is performed using the power of error signal e[n] in addition to the power of input signal x[n].

Equation 2 executes normalization processing based on an average value of the sum of the power of input signal x[n] and the power of error signal e[n]. Equation 3 executes normalization processing based on the square root of an average value of the sum of the power of input signal x[n] and the power of error signal e[n]. The processing of equation 2 and the processing of equation 3 provide substantially the same effect.

To skip the square root computation of equation 3, equation 4 executes normalization processing based on an average value of the absolute value of the product of input signal x[n] and error signal e[n]. The product of input signal x[n] and error signal e[n] represents power level, so that it is not necessary to calculate the square root and equation 4 realizes easier processing than equation 3.

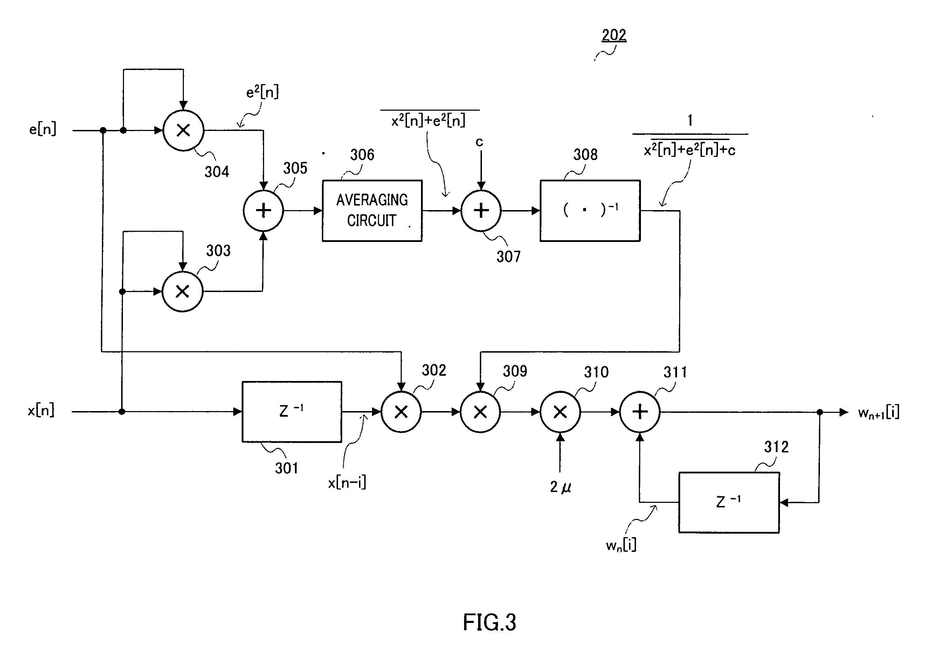

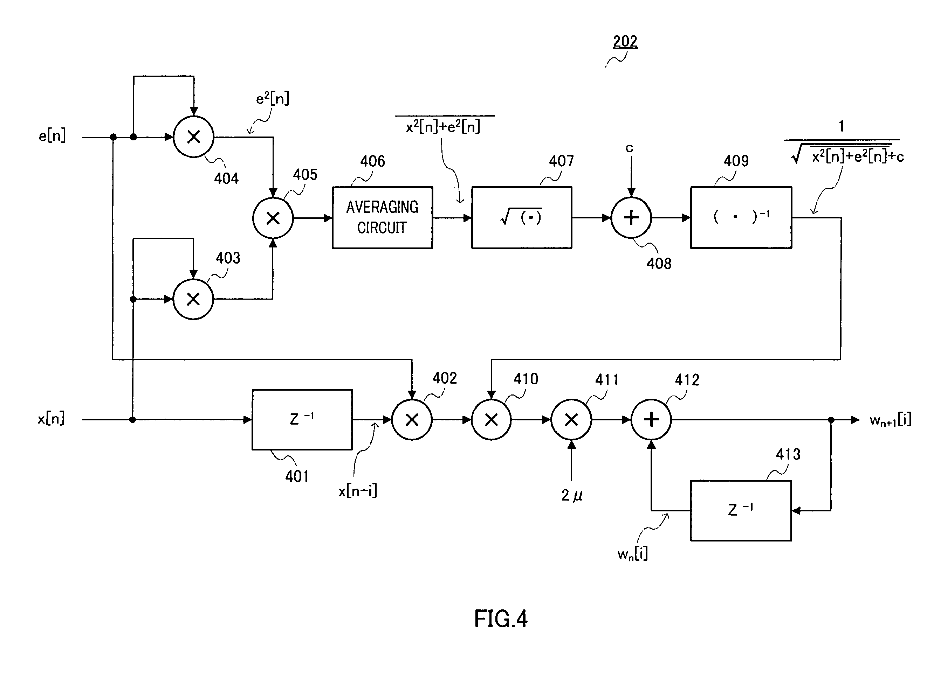

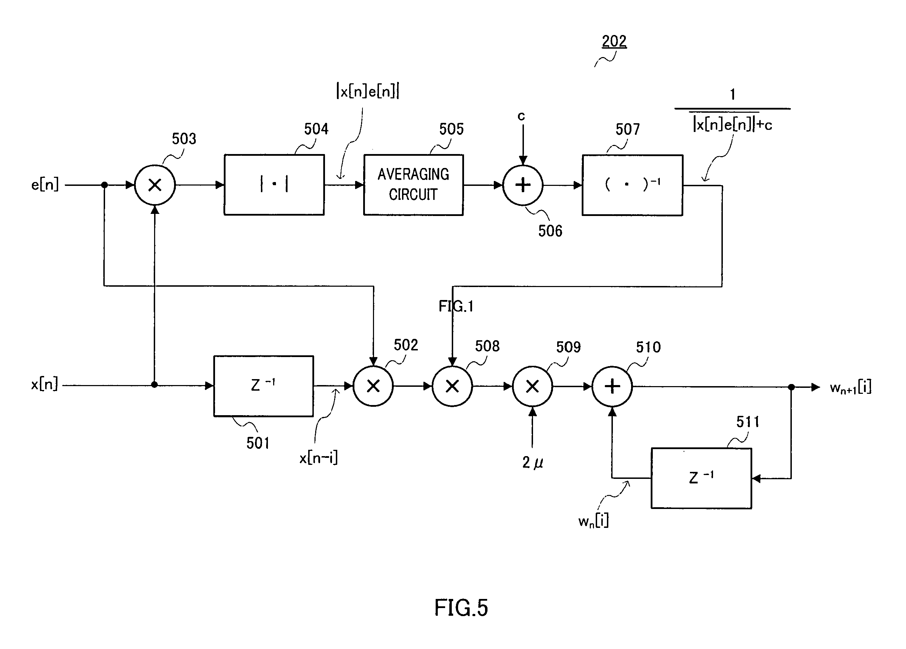

FIG.3 shows a configuration of a computation circuit in tap coefficient setting section 202 in the event of equation 2. FIG.4 shows a configuration of a computation circuit in tap coefficient setting section 202 in the event of equation 3. FIG.5 shows a configuration of a computation circuit in tap coefficient setting section 202 in the event of equation 4. In FIG.3, FIG.4 and FIG.5, +) represents an adder and (x) represents a multiplier. Also, $( \cdot )^{-1}$ represents a reciprocal computation circuit for finding the reciprocal of an input signal. $\sqrt{(\cdot)}$ represents a square root computation circuit for finding the square root of an input signal. |·| represents an absolute value computation circuit for finding the absolute value of an input signal. $z^{-i}$ represents a delay circuit for executing i-sample delay processing.

In FIG.3, tap coefficient setting section 202, calculates a numerator term of update coefficient $\Delta w_n[i]$ in delay circuit 301 and multiplier 302 using input signal $x[n]$ and error signal $e[n]$, and calculates a normalized denominator term of update coefficient $\Delta w_n[i]$ by multiplier 303, multiplier 304, adder 305, averaging circuit 306, and adder 307. Tap coefficient setting section 202 then calculates update coefficient $\Delta w_n[i]$ by dividing the numerator term by the normalized denominator term by reciprocal computation circuit 308 and multiplier 309. Then, tap coefficient setting section 202 adds update coefficient $\Delta w_n[i]$ multiplied by step size $2\mu$ to tap coefficient $w_n[i]$, in multiplier 310, adder 311 and delay circuit 312, and generates updated tap coefficient $w_{n+1}[i]$.

In FIG.4, tap coefficient setting section 202 calculates a numerator term of update coefficient $\Delta w_n[i]$ in delay circuit 401 and multiplier 402 using input signal $x[n]$ and error signal $e[n]$, and calculates a normalized denominator term of update coefficient $\Delta w_n[i]$ in multiplier 403, multiplier 404, multiplier 405, averaging circuit 406, square root computation circuit 407, and adder 408. Tap coefficient setting section 202 then calculates update coefficient $\Delta w_n[i]$ by dividing the numerator term by the normalized denominator term by reciprocal computation circuit 409 and multiplier 410. Then, tap coefficient setting section 202 adds update coefficient $\Delta w_n[i]$ multiplied by step size $2\mu$ to tap coefficient $w_n[i]$, in multiplier 411, adder 412 and delay circuit 413, and generates updated tap coefficient $w_{n+1}[i]$.

In FIG.5, tap coefficient setting section 202 calculates a numerator term of update coefficient $\Delta w_n[i]$ in delay circuit 501 and multiplier 502 using input signal $x[n]$ and error signal $e[n]$, and calculates a normalized denominator term of update coefficient $\Delta w_n[i]$ in multiplier 503, absolute value computation circuit 504, averaging circuit 505 and adder 506. Then, tap coefficient setting section 202 calculates update coefficient $\Delta w_n[i]$ by dividing the numerator term by the normalized denominator term by reciprocal computation circuit 507 and multiplier 508. Then, tap coefficient setting section 202 adds update coefficient $Aw_n[i]$ multiplied by step size $2\mu$ to tap coefficient $w_n[i]$, in multiplier 509, adder 510 and delay circuit 511, and generates updated tap coefficient $w_{n+1}[i]$.

Next, the adaptive filter of the present invention will be described assuming a case where an FLMS (Fast Least Mean Square or Frequency domain Least Mean Square) algorithm is used as an adaptation algorithm. The FLMS algorithm is an adaptation algorithm to perform block processing in the frequency domain using the discrete Fourier transform, on a regular basis, every several samples, so that the tap coefficient gradually converges to an optimal value. The FLMS algorithm may also be referred to as an FBLMS (Fast Block Least Mean Square or Frequency domain Block Least Mean Square) algorithm.

In the event the FLMS algorithm is used, the updated recurrence equation of the tap coefficient of the present invention can be represented by following equations 6 and 7. In equation 6 and equation 7, $W_n[k]$ is the discrete Fourier transform of tap coefficient $w_n[i]$, $W_{n+L}[k]$ is the discrete Fourier transform of tap coefficient $W_{n+L}[i]$, $\mu$ is the step size for adjusting the rate of convergence of the tap coefficient, $X[k]$ is the discrete Fourier transform of input signal $x[n]$, $E[k]$ is the discrete Fourier transform of error signal $e[n]$, c is a small constant of a positive value for not making the value of the denominator of the fraction 120 zero, and p is a small constant of a positive value for not making the numerator a significantly low value. Also, k represents frequency. L represents the cycle of performing coefficinet updating processing. L=1 may be calculated every time a new signal sample value is received as input. Also, the symbol "-" represents a short time average of a signal, and the symbol "*" represents the complex conjugate.

$$[6]$$
$$W_{n+L}[k] = W_n[k] + \mu \frac{E^*[k]X[k]}{\left| X[k]E[k] \right| + c}$$

$$\dots \text{(Equation 6)}$$

$$[7]$$
$$W_{n+L}[k] = W_n[k] + \mu \cdot E^*[k]X[k] \frac{\left| \overline{y[n]\,e[n]} \right| + p}{\left| X[k]E[k] \right| + c}$$

$$\dots \text{(Equation 7)}$$

In equation 6 and equation 7, unlike a conventional FLMS algorithm, normalization processing is performed using discrete Fourier transform $E[k]$ of error signal $e[n]$ in addition to discrete Fourier transform $X[k]$ of input signal $x[n]$.

In equation 6 and equation 7, $X[k]$ is determined from following equation 8 and $E[k]$ is determined from following equation 9. In equation 8 and equation 9, N is the tap length of an adaptive filter, and DFT is the discrete Fourier transform.

[8]

$$\text{DFT}\left\{x[n], x[n-1], x[n-2], \ldots, x[n-2N+2], x[n-2N+1]\right\}$$
$$\rightarrow \left\{X[0], X[1], X[2], \ldots, \dot{X}[2N-1]\right\}$$

... (Equation 8)

[9]

$$\text{DFT}\left\{e[n], e[n-1], e[n-2], \ldots e[n-N+2], e[n-N+1], \underbrace{0, \ldots, 0}_{NO's}\right\}$$
$$\rightarrow \left\{E[0], E[1], E[2], \ldots, E[2N-1]\right\}$$

... (Equation 9)

Time domain tap coefficient $w_{n+L}[i]$ can be found by performing an inverse discrete Fourier transform on frequency domain discrete Fourier transform $W_{n+1}[k]$ of the tap coefficient updated by equation 6 and equation 7, and by extracting its real part. In equation 10, IDFT represents the inverse discrete Fourier transform. Also, REAL is the processing of extracting the real part of the parameter. Normally, the fast Fourier transform algorithm is used for DFT/IDFT calculation.

[10]

$$\text{REAL}\left\{\text{IDFT}\left\{W_{n+L}[0], W_{n+L}[1], W_{n+L}[2], \ldots, W_{n+L}[2N-1]\right\}\right\}$$
$$\rightarrow \left\{w_{n+L}[0], w_{n+L}[1], \ldots, w_{n+L}[N-1], \underbrace{w_{n+L}[N], \ldots, w_{n+L}[2N-1]}_{DISCARDED}\right\}$$

... (Equation 10)

The tap coefficient length acquired from equation 10 is 2N of $w_{n+L}[0]$ to $w_{n+L}[2N-1]$, but $w_{n+L}[N]$ to $w_{n+L}[2N-1]$ are discarded and $w_{n+L}[0]$ to $w_{n+L}[N-1]$ are used as tap coefficient.

Equation 6 applies the normalization processing of equation 4 using the absolute value of the product of input signal x[n] and error signal e[n] to the FLMS algorithm to perform block processing in the frequency domain, and allows normalization processing in the frequency domain using the absolute value of the product of discrete Fourier transform X[k] of input signal x[n] and discrete Fourier transform E[k] of error signal e[n].

Equation 7 adds processing for improving the rate of conversion from the initial state upon starting the system to equation 6, and executes normalization processing using the result of dividing the absolute value of an average value of the product of output signal y[n] of an adaptive filter and error signal e[n], by the absolute value of the product of discrete Fourier transform X[k] of input signal x[n] and inverse Fourier transform E[k] of error signal e[n]. Note that the average value of the product of y[n] and e[n] needs to be calculated through integration processing of equation 5 above using a forgetting factor, and its initial value needs to be made a value other than zero. The initial value needs to be made approximately the same as the average power of input signal x[n].

The product of y[n] and e[n] can be represented as following equation 11. The symbol "*" in equation 11 is an operator to represent convolution.

[11]

$$y[n]e[n] = y[n]\{d[n] - y[n]\}$$
$$= y[n]\{g[n] + s[n] - y[n]\}$$
$$= y[n]\{g[n] - y[n]\} + s[n]y[n]$$
$$= y[n]\{g[n] - y[n]\} + s[n]\{x[n] * w_n[i]\}$$

$$\dots \text{(Equation 11)}$$

In equation 11, s[n] and x[n] are signals from different signal sources and are uncorrelated, so that, by taking the averaging interval longer, the average of the product of s[n] and x[n]*$w_n$[i], that is, the correlation between s[n] and x[n]*$w_n$[i], becomes nearly zero. The absolute value of the average value of the product of y[n] and e[n] can be represented by following equation 12.

[12]

$$\left| \overline{y[n]e[n]} \right| \cong \left| \overline{y[n]\{g[n] - y[n]\}} \right|$$

$$\dots \text{(Equation 12)}$$

When the adaptive filter is converged completely, unless g[n]=y[n], there is correlation between estimation error with respect to g[n] (g[n]-y[n]) and y[n], and the absolute value of the average of the product of y[n] and e[n] shown in equation 12 is a positive value.

The estimation error tends to be large right after the adaptive filter starts operating, and, although the value of equation 12 has a greater value right after the adaptive filter starts operating, it nevertheless approaches zero following advancement of adaptation operation toward convergence. Consequently, in adaptive filter coefficient updating processing based on equation 7, right after the start where estimator error has a significant value , the value of step size $\mu$ is equivalently big, so that the rate of convergence is accelerated. This processing does not simply improve the rate of convergence right after the adaptive filter starts operating, and provides an advantage of accelerating the convergence of the adaptive filter when the impulse response of the system (audio system) of the identification target changes suddenly and as a result of this the level of error signal e[n] increases.

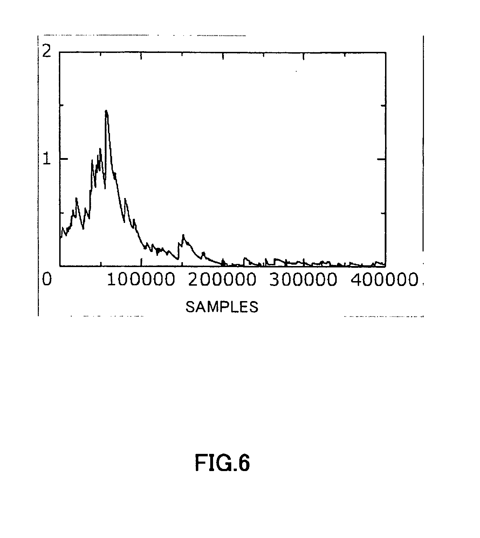

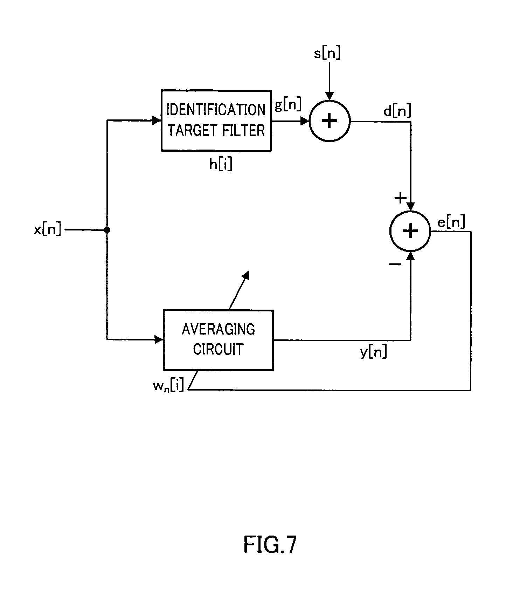

FIG.6 shows a result of actually performing a simulation with an adaptive filter using a speech signal as input signal x[n], and finding an absolute value of the average value of the product of y[n] and e[n] shown in equation 12. Note that the horizontal axis is time (unit: sample) and the vertical axis is the absolute value of the average value of the product of y[n] and e[n]. Also, in FIG.6, equation 6 is used as the coefficient updating algorithm of the adaptive filter. FIG.7 shows the system configuration upon a simulation, and for input signals x[n] and s[n], speech data from different people, recorded at a sampling frequency of 8 kHz, is used. Furthermore, the averaging processing of equation 12 is carried out by the integration processing using a forgetting factor, defined by equation 5, where the value of forgetting factor $\alpha$ is 0.02. The initial value upon performing the calculation of equation 5 is the value of the power of the first 300 samples of input signal x[n]. In FIG.7, h[i] is the tap coefficinet of the filter of the identification target, which represents the transfer function of an audio system.

As obvious from FIG.6, the absolute value of the average value of the product of y[n] and e[n] has a large value right after the operation starts, until the 10000-th sample, but becomes a value of approximately 0.3 or less after the 10000-th sample. In this case, it is preferable to make the value of constant p in equation 7 approximately 0.3 or a fraction of it.

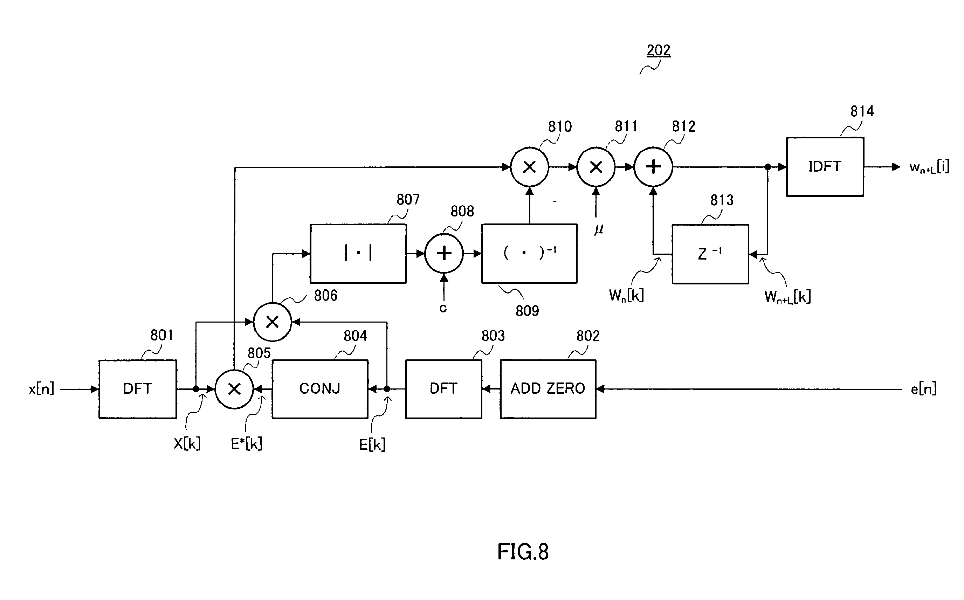

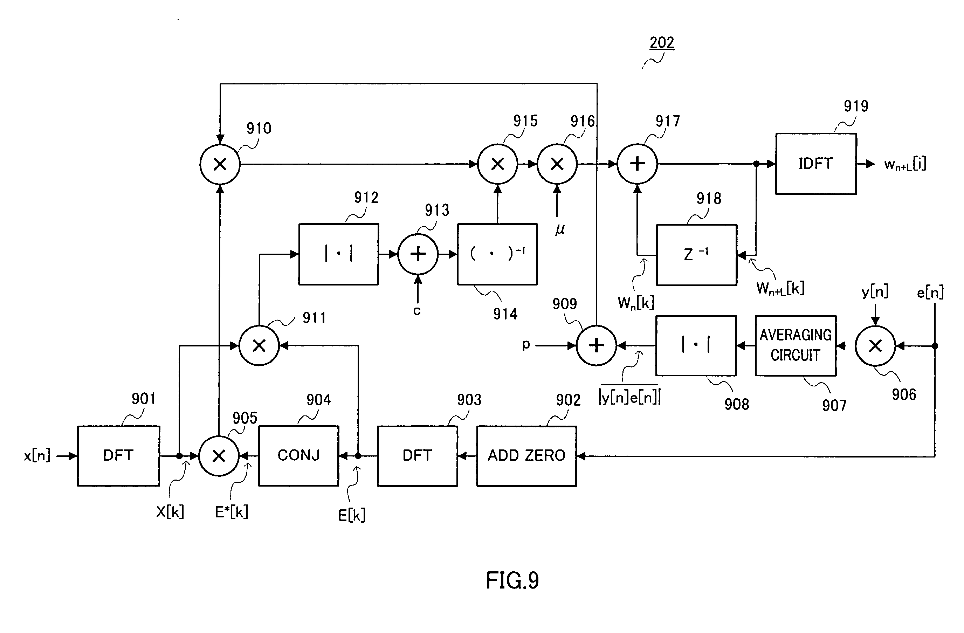

FIG.8 shows a configuration of the operation circuit in the event of equation 6 of tap coefficient setting section 202. FIG.9 shows a configuration of the computation circuit in tap coefficient setting section 202 in the event of equation 7. In FIG.8 and FIG.9, (+) represents an adder and ($\times$) represents a multiplier. Furthermore, $(\cdot)^{-1}$ represents a reciprocal computation circuit to determine the reciprocal of an input signal. $|\cdot|$ represents an absolute value computation circuit to determine the absolute value of an input signal. $z^{-i}$ represents a delay circuit to perform i-sample delay processing. DFT represents a Fourier transform circuit to perform the discrete Fourier transform. IDFT represents an inverse Fourier transform circuit to perform the discrete inverse Fourier transform. CONJ represents a complex conjugate computation circuit to find the complex conjugate of an input signal. Also, ADD ZERO represents an insertion circuit to perform processing for adding N 0's in the input numerical sequence of equation 9. REAL represents an extraction circuit to output only the real part of a complex signal that is received as input. Note that FIG.8 and FIG.9 do not show a configuration to discard unnecessary tap coefficient $w_{n+1}$ [N] to $w_{n+1}$ [2N-1] in the right side of equation 10.

In FIG.8, tap coefficient setting section 202 performs a discrete Fourier transform on input signal x[n] by means of Fourier transform circuit 801, and finds input signal vector X[k]. Also, tap coefficient setting section 202 performs a discrete Fourier transform on error signal e[n] in inserting circuit 802 and Fourier transform circuit 803, and finds error signal vector E[k]. Then, tap coefficient setting section 202 calculates a numerator term of update vector $\Delta w_n[k]$ in complex conjugate computation circuit 804 and multiplier 805, using input signal X[k] and error signal vector E[k]. Tap coefficient setting section 202 also calculates a normalized denominator term of update vector $\Delta w_n[k]$ by multiplier 806, absolute value computation circuit 807 and adder 808. Then, tap coefficient setting section 202 divides the numerator term by the normalized denominator term by reciprocal computation circuit 809 and multiplier 810 and calculates update vector $\Delta W_n[k]$. Then, tap coefficient setting section 202 adds update coefficient $\Delta w_n[k]$ multiplied by step size $\mu$ to tap coefficient $w_n[k]$, in multiplier 811, adder 812 and delay circuit 813, and generates updated tap coefficient $w_{n+L}[k]$. Tap coefficient setting section 202 then performs a discrete Fourier transform on $W_{n+L}[k]$ in inverse Fourier transform circuit 814 and finds $w_{n+L}[i]$.

In FIG.9, tap coefficient setting section 202 performs a discrete Fourier transform on input signal x[n] by means of Fourier transform circuit 901, and finds input signal vector X[k]. Also, tap coefficient setting section 202 performs a discrete Fourier transform on error signal e[n] in inserting circuit 902 and Fourier transform circuit 903, and finds error signal vector E[k]. Then, tap coefficient setting section 202 calculates a numerator term of update vector $\Delta w_n[k]$ in complex conjugate computation circuit 804 and multiplier 805, using input signal X[k] and error signal vector E[k]. Tap coefficient setting section 202 also calculates a normalized denominator term of update vector $\Delta w_n[k]$ by multiplier 806, absolute value computation circuit 807 and adder 808. Then, tap coefficient setting section 202 divides the numerator term by the normalized denominator term by reciprocal computation circuit 914 and multiplier 915 and calculates update vector $\Delta W_n[k]$. Then, tap coefficient setting section 202 adds update coefficient $\Delta w_n[k]$ multiplied by step size $\mu$ to tap coefficient $w_n[k]$, in multiplier 916, adder 917 and delay circuit 918, and generates updated tap coefficient $w_{n+L}[k]$. Tap coefficient setting section 202 then performs a discrete Fourier transform on $W_{n+L}[k]$ in inverse Fourier transform circuit 919 and finds $w_{n+L}[i]$.

A result of a computer simulation, carried out to prove the effectiveness of the adaptive filter of the present invention described above will be shown below. The system configuration upon the simulation is the same as in FIG.7. For input signal x[n] and s[n] that is equivalent to additive noise, different speakers read the same sentence to be recorded at a sampling frequency of 8 kHz and normalized such that the absolute value of the amplitude is 1 or lower. The FIR filter of the identification target and the adaptive filter both have 300 taps. The tap coefficient h[i] of the identification target filter is set as in following equation 13. The range of parameter i is $0 \leq i < 300$.

[13]

$$h[i] = 0.3 \cdot 0.985^i \cdot \sin\left(\frac{2\pi \cdot i^{0.5}}{0.4}\right)$$

... (Equation 13)

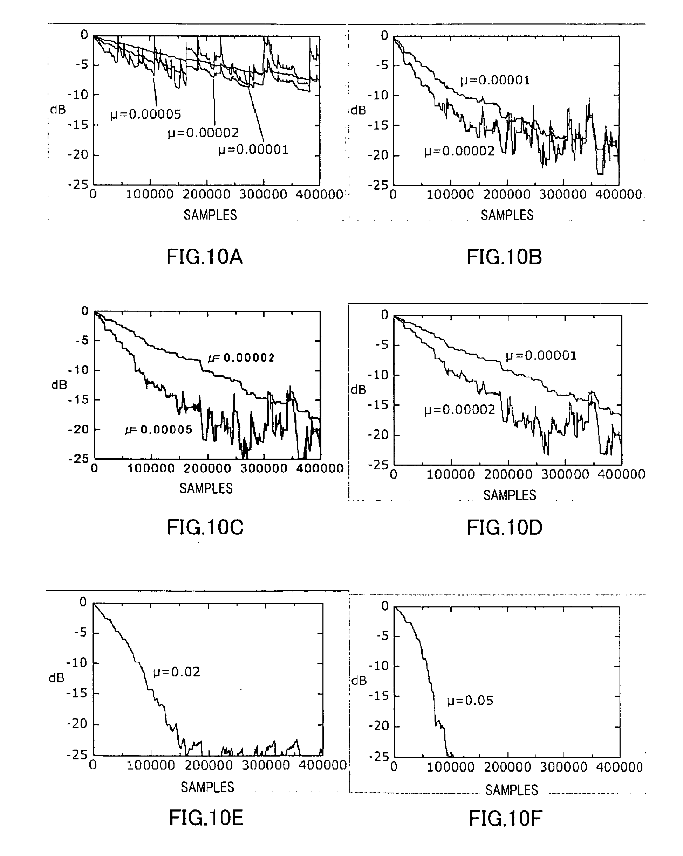

Changes with the amount of estimation error D[n] of tap coefficient h[i] of the identification target shown by equation 14 filter are shown in FIG.10. The horizontal axis in FIG.10 is time and the vertical axis is the amount of error D[n].

$$[14]$$

$$D[n] = \frac{\sum_{i=0}^{i<300} (w_n[i] - h[i])^2}{\sum_{i=0}^{i<300} (h[i])^2} \quad \dots \text{(Equation 14)}$$

FIG.10A shows a case where a conventional NLMS algorithm is used, FIG.10B shows a case where equation 2 is used, FIG.10C shows a case where equation 3 is used, FIG.10D shows a case where equation 4 is used, FIG.10E shows a case where equation 6 is used, and FIG.10F shows a case where equation 7 is used. In FIG.10E and FIG.10F, a block processing algorithm is used in the frequency domain using the DFT/IDFT, so that the tap coefficient is updated every 300 samples, which is the same as the tap length of the adaptive filter. In either example of processing, the averaging computation uses the integration computation of above equation 5 using a forgetting factor, and the value of the forgetting factor is 0.005 in FIG.10A to FIG.10D and 0.05 in FIG.10E and FIG.10F. Furthermore, the value of constant c, provided to prevent the denominator of the fraction from being 0, is 0.0001 throughout.

As shown in FIG.10A, with a conventional NLMS algorithm, it is possible to arrive at convergence being little influenced by double talk by making the value of step size $\mu$ extremely low such as 0.00001, but the rate of convergence becomes very slow. On the other hand, with a conventional NLMS algorithm, if step size $\mu$ is made 0.00002 or greater, it is not possible to maintain a stable state of convergence due to the influence of double talk.

By contrast with this, as clear from the comparison of FIG.10A with FIG.10B to 10D, by using the time-domain adaptive filter coefficient updating algorithm of the present invention, it is possible to achieve a better convergence behavior than by a conventional NLMS algorithm.

Also, as shown in FIG.10E, with the frequency domain adaptive filter coefficient updating algorithm of equation 6 according to the present invention, it is possible to achieve an even better convergence behavior than by time domain processing.

As shown in FIG.10F, with the frequency domain adaptive filter coefficient updating algorithm of equation 7 according to the present invention, it is possible to improve the convergence behavior right after start better than shown in FIG.10E. Based on the simulation result of FIG.6, the value of constant p in equation 7 is made 0.2.

Thus, while a conventional NLMS algorithm executes normalization processing using input signal power alone, with the NLMS algorithm of the adaptive filter of the present invention, normalization processing is carried out using both input signal power and error signal power.

When the power of additive noise to be added to the desired signal increases, the error sigil power also increases. According to the present invention, by performing normalization processing using error signal power as well, it is possible to automatically slow down the rate of convergence of the adaptation algorithm when the power of additive noise is large, and prevent deterioration of convergence behavior due to the influence of noise.

With an echo canceller, if a double-talk state is created, the adaptation error of the adaptive filter increases, and, accompanying this, error signal power also increases. Accordingly, like the present invention, by performing normalization processing using error signal power, it is possible to slow down the rate of conversion of the adaptive filter when a double-talk state is created and prevent adaptation error from increasing rapidly due to double talk.

Furthermore, if a double-talk state is cancelled and the power of error signal e[n] becomes lower, then the rate of convergence automatically decreases.

Furthermore, the method of processing according to the present invention does not presume the stationarity of an input signal, does not presume characteristics such as whiteness (white noise) and normal distribution, or does not presume correlation characteristics, so that, when a speech signal, with which these presumptions rarely apply, is received as input, it is possible to achieve a good convergence behavior. The only presumption which the present invention is based on is that, as shown in FIG.1, the ratio of the power of speech form a speaking party on a far-end terminal and the power of input speech s[n] varies gradually. The power of speech from different speaking parties obviously varies in an uncorrelated manner, so that this presumption holds well.

In the processing of equation 7 and equation 9 above, processing of a high rate of convergence is carried out based on a presumption related to the correlation characteristics of an input signal, but the simulation result of FIG.6 proves that this presumption holds with real speech as well.

Thus, according to the present invention, an optimal rate of convergence is maintained automatically based on far-end signal power and near-end signal power, so that it is possible to achieve a good and stable convergence behavior.

In comparison to a conventional technique of controlling the rate of convergence using a double-talk detection circuit, the present invention provides advantages of making the processing of setting a threshold for determining whether or not there is a double-talk state unnecessary and also making it unnecessary to keep setting an optimal value every time the operation environment changes.

Although an echo canceller having an adaptive filter has been described with the present embodiment, the adaptive filter of the present invention is by no means limited to an echo canceller and is applicable to other devices and apparatuses as well.

The disclosure of Japanese Patent Application No. 2008-292330, filed on November 14, 2008, including the specification, drawings, and abstract is incorporated herein by reference in its entirety.

Industrial Applicability

The present invention is suitable for use with an echo canceller, howling canceller and so on in a conventional communication system (wireless telephone, cable telephone, interphone, TV conference system).

Reference Signs List

101 Digital-to-analog converter
102 Power amplifier
103 Speaker
104 Microphone
105 Microphone amplifier
106 Analog-to-digital converter
107 Echo canceller
108 Adaptive filter
109 Subtractor
201 Filter section
202 Tap coefficient setting section
301, 312, 401, 413, 501, 511, 813, 918 Delay Circuit
302, 303, 304, 309, 310, 402, 403, 404, 405, 410, 411, 502, 503, 508, 509, 805, 806, 810, 811, 905, 906, 910, 911, 915, 916 Multiplier
305, 307, 311, 408, 412, 506, 510, 808, 812, 909, 913, 917 Adder
306, 406, 505, 907 Averaging circuit
308, 409, 507, 809, 914 Reciprocal computation circuit
407 Square root computation circuit
504, 807, 908, 912 Absolute value computation circuit
801, 803, 901, 903 Fourier transform circuit
802, 902 Inserting circuit
804, 904 Complex conjugate computation circuit
814, 919 Inverse Fourier transform circuit

**Claims**

1. An adaptive filter comprising:

   a filter section that receives input signal x[n] that is equal to an system input signal entered in a system with an unknown transfer function, and that outputs output signal y[n] by performing filtering processing of input signal x[n]; and
   a coefficient setting section that updates tap coefficient $w_n[i]$ in the filtering processing to be equal to the transfer function of the system, based on error signal e[n] representing a difference between system output signal d[n] that is output from the system and output signal y[n], and input signal x[n], where n is a sample time index and i is a parameter to represent a tap position of the adaptive filter, wherein:

   the tap coefficient setting section:

generates updated tap coefficient $w_{n+1}[i]$ by adding a result of multiplication of step size $2\mu$ and update coefficient $\Delta w_n[i]$ to tap coefficient $w_n[i]$;

generates update coefficient $\Delta w_n[i]$ by dividing a numerator term by a normalized denominator term;

generates the numerator term by multiplying input signal $x[n-i]$ by error signal $e[n]$;

generates the normalized denominator term by one of:

adding positive constant c to an average of a sum of a square of input signal $x[n]$ and a square of error signal $e[n]$;

adding positive constant c to a square root of an average of a product of the square of input signal $x[n]$ and the square of error signal $e[n]$; and

adding positive constant c to an average of an absolute value of the product of input signal $x[n]$ and error signal $e[n]$.

2. The adaptive filter according to claim 1, wherein the tap coefficient setting section generates the normalized denominator term by adding positive constant c to the average of the sum of the square root of input signal $x[n]$ and the square root of error signal $e[n]$.

3. The adaptive filter according to claim 1, wherein the tap coefficient setting section generates the normalized denominator term by adding positive constant c to the square root of the average of the product of the square of input signal $x[n]$ and the square of error signal $e[n]$.

4. The adaptive filter according to claim 1, wherein the tap coefficient setting section generates the normalized denominator term by adding positive constant c to the average of the absolute value of the product of input signal $x[n]$ and error signal $e[n]$.

5. An adaptive filter comprising:

a filter section that receives input signal $x[n]$ that is equal to an system input signal entered in a system with an unknown transfer function, and that outputs output signal $y[n]$ by performing filtering processing of input signal $x[n]$; and

a coefficient setting section that updates tap coefficient $w_n[i]$ in the filtering processing to be equal to the transfer function of the system, based on error signal $e[n]$ representing a difference between system output signal $d[n]$ that is output from the system and output signal $y[n]$, and input signal $x[n]$, where n is a sample time index and i is a parameter to represent a tap position of the adaptive filter, wherein:

the tap coefficient setting section:

generates tap coefficient vector $W_n[k]$ by performing a discrete Fourier transform on tap coefficient $w_n[i]$ (wherein k is frequency);

generates updated tap coefficient vector $Wn+L[k]$ by adding a result of multiplication of step size $\mu$ and update vector $\Delta Wn[k]$ to tap coefficient vector $Wn[k]$ (where L is a cycle of updating);

generates updated tap coefficient $w_{n+L}[i]$ by performing a discrete Fourier transform on tap coefficient vector $W_{n+L}[k]$;

generates update vector $\Delta W_n[i]$ by dividing a numerator term by a normalized denominator term;

generates the numerator term using a result of multiplication of input signal vector $X[k]$, obtained by performing a discrete Fourier transform on input signal $x[i]$, and complex conjugate $E^*[k]$ of error signal vector $E[k]$, obtained by performing a discrete Fourier transform on error signal $e[n]$; and

generates the normalized denominator term using input signal vector $X[k]$ and error signal vector $E[k]$.

6. The adaptive filter according to claim 5, wherein the tap coefficient setting section generates the numerator term by multiplying input signal vector $X[k]$ by complex conjugate $E^*[k]$ of error signal vector $E[k]$, and generates the normalized denominator term using a sum of an absolute value of a product of input signal vector $X[k]$ and error signal vector $E[k]$, and positive constant c.

7. The adaptive filter according to claim 5, wherein the tap coefficient setting section:

generates the numerator term using a product of a first numerator term obtained by multiplying input signal vector $X[k]$ by complex conjugate $E^*[k]$ of error signal vector $E[k]$, and a second numerator term obtained by adding positive constant p to an average of an absolute value of a product of output signal y[n] and error signal e[n]; and
generates the normalized denominator term by adding positive constant c to the absolute value of the product of input signal vector X[k] and error signal vector E[k].

8. An echo canceller comprising:

the adaptive filter of claim 1; and
a subtractor that generates error signal e[n] by subtracting output signal y[n] that is output from the adaptive filter, from system output signal d[n].

FIG.1

108 : ADAPTIVE FILTER

201

x[n] ──────●──────▶ FILTER SECTION ──────▶ y[n]

$w_n[i]$

202

TAP COEFFICIENT
SETTING SECTION ◀────── e[n]

FIG.2

202

$$\frac{1}{x^2[n]+e^2[n]+c}$$

308 $( \cdot )^{-1}$

307

c

$$\overline{x^2[n]+e^2[n]}$$

306 AVERAGING CIRCUIT

305

$e^2[n]$

304 ×

303 ×

e[n]

311 +

312 $z^{-1}$

$w_{n+1}[i]$

$w_n[i]$

310 × 2μ

309 ×

302 ×

301 $z^{-1}$

$x[n-i]$

x[n]

FIG.3

FIG.4

EP 2 352 237 A1

FIG.5

FIG.6

FIG.7

FIG.8

FIG.9

FIG.10A

FIG.10B

FIG.10C

FIG.10D

FIG.10E

FIG.10F

| **INTERNATIONAL SEARCH REPORT** | International application No. |
|---|---|
| | PCT/JP2009/006017 |

**A.  CLASSIFICATION OF SUBJECT MATTER**
*H04B3/23*(2006.01)i, *H03H21/00*(2006.01)i, *H04R3/02*(2006.01)i

According to International Patent Classification (IPC) or to both national classification and IPC

**B.  FIELDS SEARCHED**

Minimum documentation searched (classification system followed by classification symbols)
H04B3/20-3/23, H03H21/00, H04R3/02

Documentation searched other than minimum documentation to the extent that such documents are included in the fields searched
| | | | |
|---|---|---|---|
| Jitsuyo Shinan Koho | 1922-1996 | Jitsuyo Shinan Toroku Koho | 1996-2010 |
| Kokai Jitsuyo Shinan Koho | 1971-2010 | Toroku Jitsuyo Shinan Koho | 1994-2010 |

Electronic data base consulted during the international search (name of data base and, where practicable, search terms used)

**C.  DOCUMENTS CONSIDERED TO BE RELEVANT**

| Category* | Citation of document, with indication, where appropriate, of the relevant passages | Relevant to claim No. |
|---|---|---|
| A | JP 2008-182473 A  (Oki Electric Industry Co., Ltd.), 07 August 2008 (07.08.2008), paragraphs [0013] to [0018], [0047] to [0076]; fig. 1, 2 & US 2008/0175375 A1 | 1-4,8 |
| A | Akihiro HIRANO et al., "Sansho Shingo Power to Zatsuon Power ni Motozuku Kahen Step-size Kakuritsu Kobai Algorithm", Technical Report of IEICE, Digital Signal Processing, 26 May 1995 (26.05.1995), vol.95, no.68, pages 1 to 8 | 1-4,8 |

| ☒ Further documents are listed in the continuation of Box C. | ☐ See patent family annex. |
|---|---|

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 28 January, 2010 (28.01.10) | 09 February, 2010 (09.02.10) |

| Name and mailing address of the ISA/ | Authorized officer |
|---|---|
| Japanese Patent Office | |
| Facsimile No. | Telephone No. |

Form PCT/ISA/210 (second sheet) (April 2007)

**INTERNATIONAL SEARCH REPORT**

International application No.

PCT/JP2009/006017

C (Continuation).   DOCUMENTS CONSIDERED TO BE RELEVANT

| Category* | Citation of document, with indication, where appropriate, of the relevant passages | Relevant to claim No. |
|---|---|---|
| A | Mariko NAKANO MIYATAKE et al., 'A Time Varying Step Size Normalized LMS Algorithm for Adaptive Echo Canceler Structures', IEICE transactions on fundamentals of electronics, communications and computer sciences, 1995.02, vol.E78-A, no.2, pp.254-258 | 1-4,8 |

Form PCT/ISA/210 (continuation of second sheet) (April 2007)

**INTERNATIONAL SEARCH REPORT**

International application No.

PCT/JP2009/006017

| Box No. II | Observations where certain claims were found unsearchable (Continuation of item 2 of first sheet) |
|---|---|

This international search report has not been established in respect of certain claims under Article 17(2)(a) for the following reasons:

1. ☐ Claims Nos.:
because they relate to subject matter not required to be searched by this Authority, namely:

2. ☐ Claims Nos.:
because they relate to parts of the international application that do not comply with the prescribed requirements to such an extent that no meaningful international search can be carried out, specifically:

3. ☐ Claims Nos.:
because they are dependent claims and are not drafted in accordance with the second and third sentences of Rule 6.4(a).

| Box No. III | Observations where unity of invention is lacking (Continuation of item 3 of first sheet) |
|---|---|

This International Searching Authority found multiple inventions in this international application, as follows:

See extra sheet.

1. ☐ As all required additional search fees were timely paid by the applicant, this international search report covers all searchable claims.

2. ☐ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:

4. ☒ No required additional search fees were timely paid by the applicant. Consequently, this international search report is restricted to the invention first mentioned in the claims; it is covered by claims Nos.: 1-4, 8

**Remark on Protest**
☐ The additional search fees were accompanied by the applicant's protest and, where applicable, the payment of a protest fee.

☐ The additional search fees were accompanied by the applicant's protest but the applicable protest fee was not paid within the time limit specified in the invitation.

☐ No protest accompanied the payment of additional search fees.

Form PCT/ISA/210 (continuation of first sheet (2)) (April 2007)

**EP 2 352 237 A1**

| INTERNATIONAL SEARCH REPORT | International application No. |
|---|---|
| | PCT/JP2009/006017 |

Continuation of Box No.III of continuation of first sheet(2)

The technical feature common to the inventions of claims 1-4, 8 and the inventions of claims 5-7 relates to an adaptive filter including:

a filter unit which inputs an input signal equal to a system input signal inputted to a system having an unknown transmission function and subjects the input signal to a filter process so as to output an output signal; and

a tap coefficient setting unit which updates the tap coefficient in the filter process so as to be equal to the system transmission function according to the system output signal outputted from the system, an error signal as a difference from the output signal, and the input signal;

wherein the tap coefficient setting unit

adds to the tap coefficient, a product obtained by multiplying the step size by the update coefficient, so as to generate a tap coefficient after update,

divides the numerator term by the normalization denominator term to generate the update coefficient,

generates the numerator term by multiplying the input signal (or an input signal vector obtained by subjecting the input signal to the discrete Fourier transform) by an error signal (or a complex conjugate of an error signal vector obtained by subjecting the error signal to the discrete Fourier transform), and

generates the normalization denominator term by using the input signal (or the input signal vector) and the error signal (or the error signal vector).

However, the search has revealed that the aforementioned common technical feature is not novel since it is disclosed in Document 1 given below.

That is, Document 1 discloses an adaptive filter including:

a filter unit ("adaptive filter 11") which inputs an input signal ("reception input signal x (n)") equal to the system input signal inputted to a system having an unknown transmission function and subjects the input signal to a filter process so as to output an output signal ("pseudo echo signal y (n)"); and

a tap coefficient setting unit which updates the tap coefficient ("$h_k$ (n)") in the filter process so as to be equal to the system transmission function according to the system output signal ("transmission input signal d (n)") outputted from the system, an error signal ("residual error signal e (n)") as a difference from the output signal, and an input signal;

wherein the tap coefficient setting unit

adds a product obtained by multiplying the step size ("$\alpha$") by an update coefficient to the tap coefficient so as to generate a tap coefficient after the update,

divides the numerator term by the normalization denominator term so as to generate an update coefficient,

multiplies the input signal by the error signal so as to generate a numerator term ("$e(n) \cdot x(n-k)$" in [Expression 3]), and

generates the normalization denominator by using "$||x(n)|^2$" obtained according to the input signal and "b(n)" obtained according to the error signal ("$\mu$" in [Expression 3] in paragraph [0017] is substituted by the right side of [Expression 5] in paragraph [0060]).

(Continued to next sheet)

Form PCT/ISA/210 (extra sheet) (April 2007)

27

| INTERNATIONAL SEARCH REPORT | International application No. |
|---|---|
| | PCT/JP2009/006017 |

As a result, the aforementioned common technical feature makes no contribution over the prior art and cannot be a special technical feature within the meaning of PCT Rule 13.2, second sentence.

Since there exists no other common feature which can be considered as a special technical feature within the meaning of PCT Rule 13.2, second sentence for the inventions of claims 1-4, 8 and the inventions of claims 5-7, no technical relationship within the meaning of PCT Rule 13 between the different inventions can be seen.

Consequently, it is obvious that the inventions of claims 1-4, 8 and the inventions of claims 5-7 do not satisfy the requirement of unity of invention.

Document 1: JP 2008-182473 A (Oki Electric Industry Co., Ltd.), 07 August 2008 (07.08.2008), paragraphs [0013] – [0018], [0047] – [0076], fig. 1, fig. 2 & US 2008/0175375 A1

Form PCT/ISA/210 (extra sheet) (April 2007)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2007274714 A
- JP 2008078973 A
- JP 2008098929 A
- JP 2008292330 A